# EUROPÄISCHE PATENTSCHRIFT

(11) **EP 1 165 257 B1**
(45) Veröffentlichungstag und Bekanntmachung des Hinweises auf die Patenterteilung: **16.07.2003**
(21) Anmeldenummer: 00916985.5
(22) Anmeldetag: 21.03.2000
(51) Int. Cl.: B05D 7/24, C23C 14/00

(54) **RELEASE-SCHICHT, VERFAHREN ZU IHRER HERSTELLUNG SOWIE VERWENDUNG**
RELEASE LAYER, METHOD FOR PRODUCING THE SAME AND ITS USE
COUCHE DE SEPARATION, PROCEDE DE FABRICATION ET D'UTILISATION DE LADITE COUCHE

(30) Priorität: 15.04.1999 DE 19917075; 15.07.1999 DE 19933230
(43) Veröffentlichungstag der Anmeldung: 02.01.2002
(60) Teilanmeldung: 02022695.7
(73) Patentinhaber: FRAUNHOFER-GESELLSCHAFT ZUR FÖRDERUNG DER ANGEWANDTEN FORSCHUNG E.V., 80636 München (DE)
(72) Erfinder: MOOSHEIMER, Ulrich, D-85411 Hohenkammer (DE)
(86) Internationale Anmeldenummer: EP0002472
(87) Internationale Veröffentlichungsnummer: WO00062943

(56) Entgegenhaltungen:
- EP-A- 0 081 599
- EP-A- 0 854 024
- WO-A-96/31571
- WO-A-96/31649

## Beschreibung

Die vorliegende Erfindung bezieht sich auf eine Release-Schicht, ein Verfahren zu ihrer Herstellung sowie auf Verwendungen derartiger Release-Schichten.

Release-Schichten werden zum Ablösen einer darauf aufgebrachten Schicht verwendet. Das Endprodukt stellt die abgelöste Schicht oder die partiell abgelöste Substratfolie dar. Zum Beispiel wird die abgelöste Schicht zur Herstellung von Pigmenten oder Prägedrucken verwendet. Eine partielle Abdeckung des Substrates vor der Beschichtung mit der Release-Schicht strukturiert nach dem Ablösen der Abdeckung eine zusätzlich aufgebrachte Schicht.

Bei der Herstellung von Pigmenten, z.B. Metalleffektpigmenten auf Basis von Metallen für Lackierungen, wird auf eine lackierte Polymerfolie, z.B. Polyethylenterephthalat (PET), eine einige 10 Nanometer dicke Schicht, z.B. Aluminium, vakuumtechnisch aufgedampft. Bei Eintauchen dieser beschichteten Folie in Lösungsmittel, für Aluminium z.B. Aceton, löst sich die (Aluminium-) Schicht von der Polymerfolie. Aus der gelösten Schicht werden anschließend metallische Pigmente hergestellt. Um größere Pigmente zu erhalten, wird die Aluminiumschicht zusätzlich beschichtet. Ein derartiges Verfahren ist beispielsweise in der US 3 949 139 offenbart.

Die WO 96/31649 beschreibt die Herstellung eines mit einem Acrylatpolymer beschichteten Bandmaterials, das schließend metallisiert und mit einer weiteren Deckschicht beschichtet wird und bei dem das Acrylat auf das Substrat vakuumtechnisch aufgedampft wird.

Nach dem Stand der Technik wird die Polymerfolie zur Herstellung der Pigmente außerhalb des Vakuums lakkiert.

Bei Prägefolien erfolgt nach dem Stand der Technik die Ablösung der zweiten Schicht mittels eines erhitzten Prägestempels.

Aufgabe der vorliegenden Erfindung ist es, Release-Schichten, Verfahren zu ihrer Herstellung sowie Verwendungen derartiger Release-Schichten zur Verfügung zu stellen, die einfach und kostengünstig aufgebracht und abgelöst werden können.

Diese Aufgabe wird durch die Release-Schicht nach dem Oberbegriff des Anspruchs 1, das Verfahren zu ihrer Herstellung nach dem Oberbegriff des Anspruchs 8 in Verbindung mit ihren kennzeichnenden Merkmalen sowie durch die Verwendungen nach den Ansprüchen 6 und 7 gelöst.

Die vakuumtechnisch aufgedampfte Release-Schicht nach dieser Erfindung enthält Triazine, deren Salze oder eine Mischung davon in monomerer Form. Dadurch wird die Herstellung von Release-Schichten mit Hilfe vakuumtechnischer Beschichtungen auch beispielsweise bei niedrigen Temperaturen möglich. Als organisches Monomer wird vorteilhafterweise ein wasserlösliches organisches Monomer verwendet. Dadurch kann die Verwendung umweltschädlicher Lösungsmittel vermieden werden. Weiterhin wird durch Wasser das Substrat nicht geschädigt, so daß ein geringerer Materialverbrauch und damit geringere Produktionskosten resultieren. Bei vernachlässigbarer Schädigung des Substrates, beispielsweise einer Polymerfolie, durch den gesamten Prozeß kann dieses erneut und sogar mehrfach verwendet werden, so daß sowohl die Umweltbelastung als auch die Prozeßkosten verringert werden.

Die Release-Schicht nach dieser Erfindung enthält vorteilhafterweise 1,3,5-Triazine, deren Salze oder eine Mischung hiervon. Als Triazine kommen insbesondere Melamin, Ammelin, Ammelid, Cyanursäure, 2-Ureidomelamin, Melam, Melem, Melon oder Melaminsalze wie Melamincyanurat, Melaminphosphat, Dimelaminpyrophosphat oder Melaminpolyphosphat oder funktionalisiertes Melamin wie Hexamethoxymethyl-Melamin oder acrylatfunktionalisiertes Melamin oder einer Mischung aus den obigen Substanzen in Frage. Diese Release-Schichten sind zum Teil wasserlöslich und oft leicht zu entfernen. Vorteilhaft an der Verwendung von Melamin bzw. Melaminderivaten ist insbesondere, daß die Verdampfungstemperatur von Melamin lediglich ca. 200 °C beträgt. Dadurch tritt nur eine geringe thermische Belastung des Substrates sowie der in dem Verdampfer befindlichen Blenden oder Bänder auf. Weiterhin löst sich Melamin in warmem Wasser, so daß nicht nur die Release-Schicht mit heißem Wasser aufgelöst werden kann, sondern auch die Reinigung der zur Herstellung der Release-Schicht verwendeten Vorrichtungen einfach mit heißem Wasser durchgeführt werden kann.

Als Substrat eignen sich insbesondere flächige Materialien, insbesondere bandförmige Materialien wie Folien aus Polymeren, da diese bei der Herstellung der erfindungsgemäßen Release-Schichten nur gering thermisch belastet werden und bei der Ablösung der Release-Schicht lediglich mit Wasser in Kontakt kommen. Als Polymere eignen sich hierfür insbesondere Polyester, Polypropylen, Polyethylen, Polyamid, Polycarbonat oder deren Kombinationen. Als Materialien sind auch Papier, Karton, Metallbänder oder deren Kombinationen geeignet.

Diese erfindungsgemäßen Release-Schichten können insbesondere zur Herstellung von Nanopartikeln, zur Herstellung von Pigmenten, beispielsweise metallischen Effektpigmenten, Pigmenten aus TiO₂, SiOₓ oder anderen Oxiden, für die Lackierung oder zur Herstellung von Prägefolien als auch zur Herstellung strukturiert beschichteter Substrate verwendet werden. In letzterem Falle stellt das Substrat mit der strukturierten Oberfläche das erwünschte Produkt dar.

Bei Verwendung eines vorstrukturierten Substrates erfolgt eine Strukturierung der später abgelösten Partikel, insbesondere Nanopartikel. Somit wird die Struktur der Partikel über die Struktur des Substrates bestimmt.

Die Herstellung der erfindungsgemäßen Release-Schichten erfolgt durch vakuumtechnisches Aufbringen der Release-Schicht auf ein Substrat. Dabei kann das Substrat lediglich teilweise mit der Release-Schicht beschichtet werden, um durch Ablösung der nur teilweise aufgebrachten Release-Schicht eine strukturierte Beschichtung des Substrates mit der Deckschicht zu erzielen. Dabei kann auch das Ablösen der Release-Schicht bereits innerhalb der Vakuumkammer erfolgen, beispielsweise indem die Release-Schicht durch Erhitzten unter Vakuum entfernt wird. Es kann auch ein mehrfacher Schichtaufbau erfolgen, so daß eine unterschiedliche Anzahl von Deckschichten in verschiedenen Bereichen des Substrats anschließend abgelöst werden können. Die weiteren Schichten und Deckschichten müssen nicht notwendigerweise vakuumtechnisch aufgebracht werden. Besonders vorteilhaft ist es jedoch, wenn die weiteren Deckschichten und die Release-Schicht/Release-Schichten in derselben Vakuumkammer aufgedampft werden, beispielsweise durch hintereinander angeordnete Verdampfungsquellen. Dadurch erfolgt die gesamte Substratbeschichtung in lediglich einem Arbeitsgang und es ergeben sich verringerte Herstellungskosten.

Die weiteren Deckschichten müssen selbstverständlich nicht notwendigerweise organische Monomere enthalten sondern können auch wie im Stand der Technik anorganische Schichten, wie beispielsweise Aluminium-Schichten oder Oxidschichten sein. Die Release-Schicht kann auch durch, gegebenenfalls mehrfaches, Lackieren, Beschichten oder Kaschieren mit der Deckschicht versehen werden. Die Beschichtung kann in einer weiteren Vakuumanlage erfolgen.

Als Verfahren zur vakuumtechnischen Aufbringung der Release-Schicht/Release-Schichten beziehungsweise der Deckschicht/Deckschichten stehen neben weiteren Verfahren insbesondere thermisches Verdampfen, Kathodenzerstäubung oder chemische Gasphasenabscheidung (CVD) zur Verfügung. Dabei kann das Substrat vor dem Aufdampfen jeder einzelnen Schicht mit einer Plasmaquelle vorbehandelt werden, um die Anhaftung der aufzutragenden Schicht auf der zuvor aufgetragenen Schicht zu verbessern.

Im folgenden werden Beispiele der erfindungsgemäßen Release-Schicht sowie Beispiele vom Verfahren zu ihrer Herstellung beschrieben.

Es zeigen
Figur 1 den prinzipiellen Aufbau einer herkömmlichen Vakuum-Bandbedampfungsanlage und
Figur 2 den prinzipiellen Aufbau einer Vakuum-Bedampfungsanlage für das erfindungsgemäße Verfahren;
Figur 3 den prinzipiellen Aufbau einer weiteren Vakuum-Bedampfungsanlage für das erfindungsgemäße Verfahren;
Figur 4 den prinzipiellen Aufbau einer weiteren Vakuum-Bedampfungsanlage für das erfindungsgemäße Verfahren.

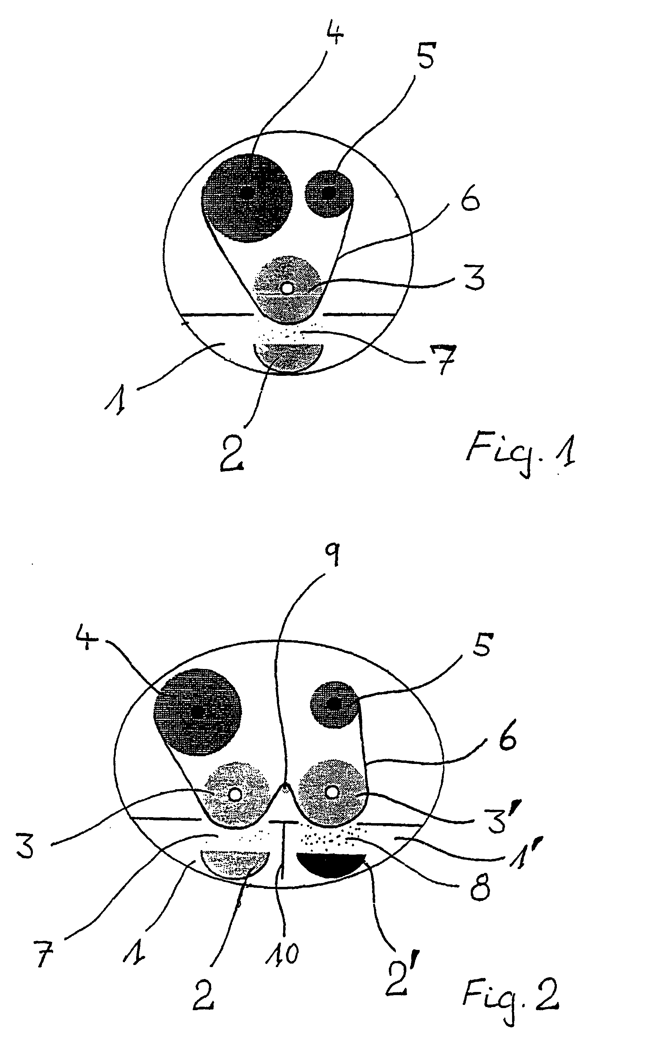

Die Vakuum-Bedampfungsanlage nach dem Stand der Technik, wie sie in Figur 1 gezeigt ist, besitzt eine Beschichtungskammer 1, in der sich ein Verdampfer 2 befindet. Mit diesem Verdampfer 2 wird das Material für eine herkömmliche Release-Schicht in eine Gasphase 7 überführt. Weiterhin weist diese herkömmliche Anlage eine Abwickelrolle 4 und eine Aufwickelrolle 5 für eine Polymerfolie 6 auf. Diese Folie wird über eine Beschichtungswalze 3 geführt, und taucht dadurch in die Gasphase 7 des aufzutragenden Materiales ein. Dadurch wird die Polymerfolie mit der Release-Schicht beschichtet. Anschließend an diese in der Vakuum-Bandbedampfungsanlage erfolgte Beschichtung wird die Folie außerhalb dieser Anlage beispielsweise lackiert.

Figur 2 zeigt den Aufbau einer Vakuum-Bandbedampfungsanlage für das erfindungsgemäße Verfahren. Diese Bandbedampfungsanlage weist zwei Beschichtungskammern 1, 1' auf, die voneinander durch eine Zwischenwand 10 getrennt sind. Wie bei der herkömmlichen Bandbedampfungsanlage sind zwei Wickelrollen 4, 5 in der Bandbedampfungsanlage angeordnet, um eine Polymerfolie von der Abwickelrolle 4 auf die Aufwickelrolle 5 zu wickeln. Die Polymerfolie 6 wird dabei über eine Beschichtungswalze 3 eine Umlenkrolle 9 sowie eine Beschichtungswalze 3' geführt.

In den jeweiligen Beschichtungskammern 1, 1' befindet sich jeweils ein Verdampfer 2, 2'. Der Verdampfer 2 verdampft dabei Melamin zur Erzeugung einer Release-Schicht auf dem Polymerband 6. Der Verdampfer 2' enthält Metalle, um auf der Folie 6 eine Pigmentschicht abzulagern. Die Beschichtungswalze 3 ist dabei in der Nähe des Verdampfers 2 und die Be-schichtungswalze 3' des Verdampfers 2' so angeordnet, daß die um diese Beschichtungswalzen geführte Polymerfolie aus Polyethylenterephthalat (PET) in die von den jeweiligen Verdampfern erzeugte Gasphase eintaucht. Zwischen den beiden Beschichtungswalzen 3 und 3' wird die Polymerfolie über eine Umlenkrolle 9 geführt.

In der beschriebenen Vakuum-Bandbedampfungsanlage wird nunmehr die Polymerfolie von der Abwickelwalze 4 über die Beschichtungswalze 3 geführt und dabei mit einer Melaminschicht als Release-Schicht versehen. Über die Umlenkrolle 9 wird die Polymerfolie 6 dann wiederum aus der Melamingasphase herausgeführt und anschließend in die metallische Gasphase, die von dem Verdampfer 2' erzeugt wird, eingebracht. Dort wird die melaminbeschichtete Polymerfolie 6 mit Metallpigmenten beschichtet. Anschließend wird die fertige Polymerfolie auf die Aufwickelwalze 5 aufgewickelt.

Bei dem hier beschriebenen Verfahren tritt aufgrund der niedrigen Verdampfungstemperatur von ca. 250 °C in dem Verdampfer 2 nur eine geringe thermische Belastung der Polymerfolie und der Beschichtungsblenden bzw. Zwischenwände 10 auf. Weiterhin können diese einfach mit heißem Wasser von dem aufgetragenen Melamin gereinigt werden.

Vorteilhaft an der beschichteten Polymerfolie ist, daß die Release-Schicht aus Melamin durch Eintauchen in heißem Wasser aufgelöst werden kann und sich dadurch die zweite aufgedampfte Metallpigmentschicht von der Polymerfolie 6 ablöst.

Figur 3 zeigt eine weitere Beschichtungskammer für das erfindungsgemäße Verfahren, wobei ähnliche Teile mit entsprechenden Bezugszeichen wie in Figur 2 versehen sind. Die Vakuum-Bandbedampfungsanlage in Figur 3 weist wiederum eine Abwickelwalze 4 und eine Aufwickelwalze 5 für eine Folie 6 auf. Diese Folie 6 wird um eine Bedampfungswalze 3 herumgeführt. Seitlich und unterhalb der Bedampfungswalze 3 sind zwei Bedampfungskammern 1, 1' angeordnet mit jeweiligen Verdampfern 2 bzw. 2'. Der Verdampfer 2 ist in dem Bereich angeordnet, in dem die Folie 6 zwischen der Abwickelwalze 4 und der Bedampfungswalze 3 gespannt ist. Durch ihn wird Melamin als Release-Schicht auf die Folie 6 aufgetragen. Mit dem Verdampfer 2', der sich unterhalb der Bedampfungswalze 3 befindet, wird die Folie mit Metallpigmenten beschichtet, bevor sie wieder auf die Aufwickelwalze 5 aufgewickelt wird.

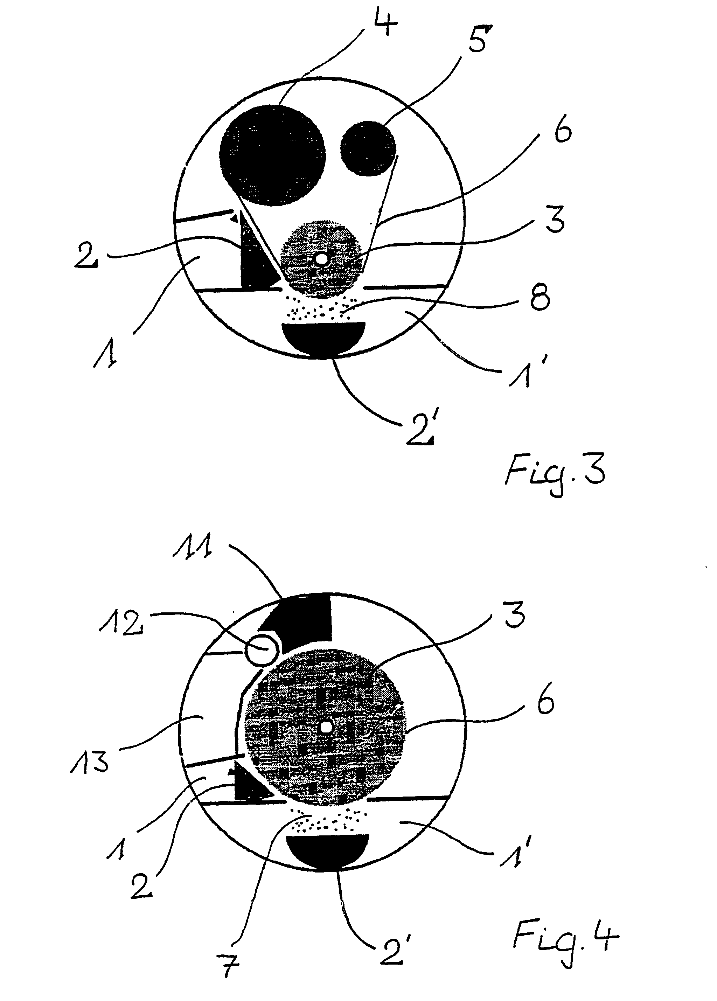

In Figur 4 ist ein anderes Prinzip zur Erzeugung von Metallpigmentpartikeln mittels des erfindungsgemäßen Verfahrens beschrieben. Die Vakuum-Bedampfungsanlage aus Figur 4 ist wiederum bei entsprechenden Teilen mit entsprechenden Bezugszeichen wie in Figur 3 versehen. Sie weist wiederum zwei Bedampfungskammern 1, 1' mit jeweils einem Verdampfer 2, 2' auf, die beide um eine Bedampfungswalze 3 angeordnet sind. Im Gegensatz zu Figur 3 wird hier jedoch ein auf der Bedampfungswalze 3 umlaufendes Metallband oder die Metallwalze selbst von den Bedampfern beschichtet, statt einer um die Bedampfungswalze 3 herumgeführten Folie. In der Beschichtungskammer 1 wird zuerst die Metallwalze 3 bzw. das auf dieser umlaufende Metallband 6 mit Melamin und anschließend in der Bedampfungskammer 1' mit Metallpartikeln, wie beispielsweise Aluminium, beschichtet. Auf dem weiteren Umfang der Bedampfungswalze 3 ist eine Wärmequelle 11 sowie eine Ablösewalze 12 und eine Ablösekammer 13 angeordnet. Ein auf der Bedampfungswalze durch die Verdampfer 2 und 2' mit Melamin und Aluminium beschichteter Bereich der Bedampfungswalze 3 bzw. des umlaufenden Bandes läuft während einer Umdrehung der Bedampfungswalze 3 bzw. des umlaufenden Bandes folglich auch an der Wärmequelle und der Ablösewalze 12 vorbei. Von der Wärmequelle 11 wird die Bedampfungswalze 3 bzw. das umlaufende Band auf ca. 250 °C aufgeheizt. Dadurch verdampft im Bereich der Wärmequelle 11 und der Ablösewalze 12 das Melamin und das oberhalb dieser Melamin-Release-Schicht aufgetragene Aluminium löst sich von der Metallwalze 3 bzw. dem auf dieser umlaufenden Metallband 6. Das Aluminiumpigment wird anschließend in der Ablösekammer 13 gewonnen und aus der Vakuumkammer entfernt. Damit steht der nunmehr melamin- und aluminiumfreie Bereich auf der Metallwalze 3 bzw. dem auf dieser umlaufenden Metallband 6 wiederum zur Bedampfung in den Bedampfungskammern 1 und 1' mit Melamin und Aluminium zur Verfügung. Der Vorteil dieses Verfahrens liegt im kontinuierlichen Betrieb der Anlage, da kein Rollenwechsel von Abwickelrollen 4 und Aufwickelrollen 5 und Rollenmaterial 6 wie bei den Figuren 1 bis 3 beschrieben, notwendig ist.

Weitere Möglichkeiten einer Vorrichtung und eines Verfahrens wie zu Figur 4 beschrieben, bestehen darin, daß die Ablösung der aufgedampften Schichten im Vakuum erfolgen kann, das heißt, beispielsweise die Ablösekammer 13 unter Vakuum steht. Als Ablöseverfahren stehen außer Erhitzen der Walze 3 oder des umlaufenden Bandes an der entsprechenden Stelle auch Verfahren unter Verwendung von Elektronenstrahlen, Laser und/oder Photonenstrahlung bzw. Infrarotstrahlung zur Verfügung. Der Ablösevorgang kann auch so gesteuert werden, daß vor dem Ablösen die Qualität der aufgedampften Schichten mit geeigneten Methoden geprüft wird und anschließend die Schichten, die die gewünschten Qualitätsmerkmale zeigen, partiell und/oder in Stufen, z.B. in verschiedenen Ablösekammern, in Abhängigkeit von ihrer Qualität abgelöst werden.

## Patentansprüche

1. Vakuumtechnisch aufgedampfte Release-Schicht auf einem Substrat,
**dadurch gekennzeichnet, daß** sie im wesentlichen aus Triazinen oder deren Salze bzw. einer Mischung davon in monomerer Form besteht.

2. Release-Schicht nach dem vorhergehenden Anspruch, **dadurch gekennzeichnet, daß** sie ein 1,3,5-Triazin oder dessen Salz bzw. eine Mischung davon enthält.

3. Release-Schicht nach mindestens einem der vorhergehenden Ansprüche, **dadurch gekennzeichnet, daß** sie Melamin, Ammelin, Ammelid, Cyanursäure, 2-Ureidomelamin, Melam, Melem, Melon oder Melaminsalze wie Melamincyanurat, Melaminphosphat, Dimelaminpyrophosphat oder Melaminpolyphosphat oder funktionalisiertes Melamin wie Hexamethoxymethyl-Melamin oder acrylatfunktionalisiertes Melamin oder eine Mischung davon enthält.

4. Release-Schicht nach mindestens einem der vorhergehenden Ansprüche, **dadurch gekennzeichnet, daß** das Substrat aus flächigen, insbesondere bahnförmigen Materialien wie beispielsweise Folien aus Polymeren wie beispielsweise Polyester, Polypropylen, Polyethylen, Polyamid, Polycarbonat, Papier, Karton, Metallbänder oder deren Kombinationen besteht.

5. Release-Schicht nach mindestens einem der vorhergehenden Ansprüche, **dadurch gekennzeichnet, daß** das Substrat vorstrukturiert ist, beispielsweise als geprägte bandförmige Materialien, beispielsweise aus Metallen oder Kunststoffen oder durch Lackierung, beispielsweise UV-härtbare Lackierung.

6. Verwendung einer Release-Schicht nach mindestens einem der Ansprüche, zur Herstellung von Nanopartikeln, zur Herstellung von Pigmenten, beispielsweise metallischen Effektpigmenten, für die Lackierung oder zur Herstellung von Prägefolien.

7. Verwendung einer Release-Schicht nach mindestens einem der Ansprüche 1 bis 5, zur Herstellung strukturierter Oberflächen auf einem Substrat.

8. Verfahren zum Herstellen einer Release-Schicht nach mindestens einem der Ansprüche 1 bis 5 auf einem Substrat, **dadurch gekennzeichnet, daß** die Release-Schicht vakuumtechnisch auf das Substrat aufgebracht wird.

9. Verfahren nach dem vorhergehenden Anspruch, **dadurch gekennzeichnet, daß** das Substrat nur teilweise mit der Release-Schicht beschichtet wird.

10. Verfahren nach einem der Ansprüche 8 oder 9, **dadurch gekennzeichnet, daß** auf die Release-Schicht mindestens eine weitere Deckschicht aufgebracht wird.

11. Verfahren nach dem vorhergehenden Anspruch, **dadurch gekennzeichnet, daß** die mindestens eine weitere Deckschicht und die Release-Schicht in derselben Vakuumkammer aufgedampft werden.

12. Verfahren nach mindestens einem der beiden vorhergehenden Ansprüche, **dadurch gekennzeichnet, daß** die Release-Schicht und gegebenenfalls die mindestens eine weitere Deckschicht durch thermisches Verdampfen, Kathodenzerstäubung oder CVD aufgedampft wird.

13. Verfahren nach mindestens einem der drei vorhergehenden Ansprüche, **dadurch gekennzeichnet, daß** als weitere Deckschichten anorganische Schichten, wie Al-Schichten oder Oxid-Schichten aufgedampft werden.

14. Verfahren nach mindestens einem der Ansprüche 8 bis 13, **dadurch gekennzeichnet, daß** die Release-Schicht anschließend, gegebenenfalls mehrfach, lackiert, beschichtet oder kaschiert wird.

15. Verfahren nach mindestens einem der Ansprüche 8 bis 14, **dadurch gekennzeichnet, daß** das Substrat vor dem Aufdampfen einer der Schichten mit einer Plasmaquelle vorbehandelt wird.

16. Verfahren nach einem der Ansprüche 8 bis 15, **dadurch gekennzeichnet, daß** die Release-Schicht und gegebenenfalls die weiteren Deckschichten anschließend abgelöst wird.

17. Verfahren nach Anspruch 16, **dadurch gekennzeichnet, daß** die Release-Schicht und die gegebenenfalls weiteren Deckschichten durch Erhitzen und/oder unter Verwendung von Elektronenstrahlen, Laser, Photonenstrahlung und/oder Infrarotstrahlung abgelöst wird.

18. Verfahren nach Anspruch 16 oder 17, **dadurch gekennzeichnet, daß** die Release-Schicht und gegebenenfalls die weiteren Deckschichten im Vakuum abgelöst wird.

19. Verfahren nach einem der Ansprüche 16 bis 18, **dadurch gekennzeichnet, daß** vor dem Ablösen der Release-Schicht und gegebenenfalls der weiteren Deckschichten die Qualität der aufgedampften Schichten mit geeigneten Methoden geprüft wird und anschließend die Schichten, die die gewünschten Qualitätsmerkmale zeigen, partiell und/oder in Stufen, beispielsweise in verschiedenen Ablösekammern, in Abhängigkeit von ihrer Qualität abgelöst werden.

## Claims

1. Vacuum-deposited release layer on a substrate, **characterised in that** it is essentially composed of triazines or their salts or a mixture thereof in monomer form.

2. Release layer according to the preceding claim, **characterised in that** it contains a 1,3,5-triazine or its salt or a mixture thereof.

3. Release layer according to at least one of the preceding claims, **characterised in that** it contains melamine, ammeline, ammelide, cyanuric acid, 2-ureidomelamine, melam, melem, melon or melamine salts such as melamine cyanurate, melamine phosphate, dimelamine pyrophosphate or melamine polyphosphate or functionalised melamine such as hexamethoxymethyl melamine or acrylate-functionalised melamine or a mixture thereof.

4. Release layer according to at least one of the preceding claims, **characterised in that** the substrate is composed of sheet materials, in particular web-type materials, such as foils made of polymers such as, for example, polyester, polypropylene, polyethylene, polyamide, polycarbonate, paper, cardboard, metal bands, or combinations thereof.

5. Release layer according to at least one of the preceding claims, **characterised in that** the substrate is pre-structured, e.g. as embossed band-type materials made of metals or plastics, for example, or by lacquering, e.g. uv-hardenable lacquering.

6. Use of a release layer according to at least one of the claims, for the production of nano-particles, for the production of pigments, e.g. metallic effect pigments, for lacquering or for the production of blocking foils.

7. Use of a release layer according to at least one of Claims 1 to 5, for the production of structured surfaces on a substrate.

8. Process for the production of a release layer according to at least one of Claims 1 to 5 on a substrate, **characterised in that** the release layer is vacuum-deposited onto the substrate.

9. Process according to the preceding claim, **characterised in that** the substrate is only partially coated with the release layer.

10. Process according to one of Claims 8 or 9, **characterised in that** at least one further coating is applied to the release layer.

11. Process according to the preceding claim, **characterised in that** the at least one further coating and the release layer are deposited in the same vacuum chamber.

12. Process according to at least one of the two preceding claims, **characterised in that** the release layer, and possibly the at least one further coating, is deposited by thermal evaporation, cathode sputtering or CVD.

13. Process according to at least one of the three preceding claims, **characterised in that** inorganic layers such as Al layers or oxide layers are deposited as further coatings.

14. Process according to at least one of Claims 8 to 13, **characterised in that** the release layer is subsequently lacquered, coated or laminated, possibly several times.

15. Process according to at least one of Claims 8 to 14, **characterised in that** the substrate is pre-treated with a plasma source before deposition of one of the layers.

16. Process according to one of Claims 8 to 15, **characterised in that** the release layer, and possibly the further coatings, is subsequently detached.

17. Process according to Claim 16, **characterised in that** the release layer, and possibly further coatings, is detached by heating and/or by using electron beams, lasers, photon radiation and/or infrared radiation.

18. Process according to Claim 16 or Claim 17, **characterised in that** the release layer, and possibly the further coatings, is detached in the vacuum.

19. Process according to one of Claims 16 to 18, **characterised in that** prior to detachment of the release layer, and possibly the further coatings, the quality of the deposited layers is checked using appropriate methods, and the layers exhibiting the desired quality features are then partially detached and/or detached in stages, e.g. in different detachment chambers, depending on their quality.

## Revendications

1. Couche de séparation vaporisée par une technique sous vide sur un substrat,
**caractérisée en ce qu'**
elle se compose essentiellement de triazines ou de ses sels, ou selon les cas de leurs mélanges sous forme monomère.

2. Couche de séparation selon la revendication précédente,
**caractérisée en ce qu'**
elle contient une 1,3,5-triazine ou un de ses sels ou selon les cas un de leurs mélanges.

3. Couche de séparation selon au moins une des revendications précédentes,
**caractérisée en ce qu'**
elle contient de la mélamine, de l'amméline, de l'ammélide, de l'acide cyanurique, de la 2-uréidomélamine, du melam, du melem, du melon ou des sels de mélamine comme le cyanurate de mélamine, le phosphate de mélamine, le pyrophosphate de dimélamine ou le polyphosphate de mélamine ou une mélamine fonctionnalisée comme l'hexaméthoxyméthyl mélamine ou une mélamine fonctionnalisée par un acrylate, ou un de leurs mélanges.

4. Couche de séparation selon au moins une des revendications précédentes,
**caractérisée en ce que**
le substrat se compose de matériaux plats, en particulier sous forme de lés, comme par exemple des feuilles de polymère, comme par exemples des polyesters, de polypropylène, de polyéthylène, de polyamide, de polycarbonates, de papiers, de bandes métalliques ou de leurs combinaisons.

5. Couche de séparation selon au moins une des revendications précédentes,
**caractérisée en ce que**
le substrat est préstructuré, par exemple sous forme de matériaux en forme de bande estampée, par exemple en métaux et en matières synthétiques, ou par vernissage, par exemple par un vernissage durcissable aux UV.

6. Utilisation d'une couche de séparation selon au moins une des revendications pour la production de nanoparticules, pour la production de pigments, par exemple de pigments à effet métallique, pour le vernissage ou pour la production de feuilles estampées.

7. Utilisation d'une couche de séparation selon au moins une des revendications 1 à 5, pour la production de surfaces structurées sur un substrat.

8. Procédé de production d'une couche de séparation selon au moins une des revendications 1 à 5 sur un substrat,
**caractérisé en ce que**
la couche de séparation est déposée sur le substrat par une technique sous vide.

9. Procédé selon la revendication précédente,
**caractérisé en ce que**
le substrat n'est que partiellement revêtu avec la couche de séparation.

10. Procédé selon l'une des revendications 8 ou 9,
**caractérisé en ce qu'**
au moins une autre couche de revêtement est déposée sur la couche de séparation.

11. Procédé selon l'une des revendications précédentes,
**caractérisé en ce qu'**
au moins une autre couche de revêtement et la couche de séparation sont vaporisées dans la même chambre sous vide.

12. Procédé selon l'une des deux revendications précédentes,
**caractérisé en ce que**
la couche de séparation et le cas échéant au moins une autre couche de revêtement sont vaporisés par une vaporisation thermique, une pulvérisation cathodique ou par CVD.

13. Procédé selon au moins une des trois revendications précédentes,
**caractérisé en ce qu'**
on vaporise comme autres couches de revêtement des couches inorganiques, comme des couches d'aluminium comme des couches d'oxyde.

14. Procédé selon au moins une des revendications 8 à 13,
**caractérisé en ce que**
la couche de séparation est ensuite, le cas échéant plusieurs fois, revêtue ou enduite.

15. Procédé selon au moins une des revendications 8 à 14,
**caractérisé en ce que**
le substrat est prétraité avant vaporisation d'une des couches avec une source de plasma.

16. Procédé selon l'une des revendications 8 à 15,
**caractérisé en ce que**
la couche de séparation et le cas échéant les autres couches de revêtement sont ensuite séparées.

17. Procédé selon la revendication 16,
**caractérisé en ce que**
la couche de séparation et les éventuelles autres couches de revêtement sont séparées par chauffage et/ou en utilisant des rayons électroniques, un laser, un rayonnement photonique et/ou un rayonnement infrarouge.

18. Procédé selon la revendication 16 ou 17,
**caractérisé en ce que**
la couche de séparation et le cas échéant les autres couches de revêtement sont séparées sous vide.

19. Procédé selon l'une des revendications 16 à 18,
**caractérisé en ce qu'**
avant la séparation de la couche de séparation et le cas échéant des autres couches de revêtement, on vérifie avec des procédés appropriés la qualité des couches vaporisées, et ensuite on sépare les couches qui présentent les caractéristiques de qualité désirées, partiellement ou par étapes, par exemple dans diverses chambres de séparation, en fonction de leur qualité.
